# EUROPÄISCHE PATENTSCHRIFT

(11) **EP 2 743 373 B1**
(45) Veröffentlichungstag und Bekanntmachung des Hinweises auf die Patenterteilung: **24.06.2015**
(21) Anmeldenummer: 13192939.0
(22) Anmeldetag: 14.11.2013
(51) Int. Cl.: C23C 16/455, C23C 16/513, C23C 16/448

(54) **Dosiereinheit und ihre Verwendung**
Metering unit and use of the same
Unité de dosage et son utilisation

(30) Priorität: 16.11.2012 DE 102012220986
(43) Veröffentlichungstag der Anmeldung: 18.06.2014
(73) Patentinhaber: Innovent e.V., 07745 Jena (DE)
(72) Erfinder: BEIER, Oliver, 07407 Rudolstadt (DE); KRIPPL, Gerhardt, 07646 Stadtroda (DE); RAMM, Max, 07768 Kahla (DE); SPANGE, Sebastian, 07745 Jena (DE)
(74) Vertreter: Liedtke, Markus

(56) Entgegenhaltungen:
- EP-A1- 1 492 160
- EP-A1- 2 187 708
- EP-A1- 2 187 709
- EP-A1- 2 190 263
- EP-B1- 0 849 375
- WO-A2-2007/098438

## Beschreibung

Die Erfindung betrifft eine Dosiereinheit für eine Vorrichtung zur Abscheidung einer Schicht auf einem Substrat und eine Verwendung der Dosiereinheit bei einem Verfahren zur Abscheidung einer Schicht auf einem Substrat.

Um die Oberflächeneigenschaften verschiedener Substrate zu beeinflussen, sind seit geraumer Zeit Beschichtungsverfahren gebräuchlich, bei denen Beschichtungsstoffe aus einer Gasphase auf einer Oberfläche abgeschieden werden. Dabei wird unter anderem zwischen chemischen und physikalischen Gasphasenabscheidungen unterschieden. Bei den chemischen Verfahren werden meist so genannte Precursoren, Vorläuferstoffe der Beschichtungsstoffe, mittels Energiezuführung umgesetzt, Reaktionsprodukte der Precursoren auf die Oberfläche geleitet und dort abgelagert. Die Energiezuführung kann beispielsweise mittels Beflammung erfolgen. Der der Flamme zugeführte Precursor bildet bei seiner thermischen Umsetzung Partikel, insbesondere Nanopartikel, die noch in der Flamme agglomerieren und sich dann an der Oberfläche absetzen. Auf diese Weise ist eine homogene und dichte Beschichtung möglich, jedoch unter hohem Energieeinsatz. Eine andere Möglichkeit bieten so genannte Niederdruckplasmaverfahren, bei denen der Precursor in einer Plasmaquelle oder in deren räumlicher Nähe auf den zu beschichtenden Oberflächen zu Dünnschichten umgesetzt wird.

Seit einigen Jahren sind so genannte Normaldruckplasmaverfahren bekannt, bei denen die zu beschichtenden Oberflächen nicht in ein Vakuum eingebracht werden müssen. Die Partikelbildung erfolgt hierbei schon im Plasma. Die Homogenität der abgeschiedenen Schichten ist, eine geeignete Führung des Substrats vorausgesetzt, mit den durch Beflammung erzielten vergleichbar, der erforderliche thermische Energieeintrag ist jedoch wesentlich geringer.

Aus der DE 199 58 473 A1, der DE 199 58 474 A1 und der US 2003/0215644 A1 sind gattungsgemäße Verfahren zum Beschichten von Substraten bekannt. Bei diesen bekannten Verfahren wird aus einem Arbeitsgas eine Flamme oder ein Plasmastrahl erzeugt, in die jeweils ein Precursor eingebracht wird.

Der Erfindung liegt die Aufgabe zu Grunde, eine verbesserte Dosiereinheit zum Eindosieren eines Precursors in einen Gasstrom und eine Verwendung der Dosiereinheit in einem verbesserten Verfahren zur Abscheidung einer Schicht auf einem Substrat anzugeben.

Die Aufgabe wird erfindungsgemäß gelöst durch eine Dosiereinheit mit den Merkmalen des Anspruchs 1 und durch eine Verwendung mit den Merkmalen des Anspruchs 5.

Vorteilhafte Ausgestaltungen der Erfindung sind Gegenstand der Unteransprüche.

Eine erfindungsgemäße Dosiereinheit zum Eindosieren eines Precursors in einen Gasstrom umfasst einen Basiskörper mit einem ersten Kanal, der von einem Gaseintritt zu einem Gasaustritt vom Gasstrom durchströmbar ist, und mit einem zweiten Kanal, der den ersten Kanal unter einem Winkel an einem Kreuzungspunkt schneidet, wobei eine Einsprühdüse zum Zuführen des Precursors in den Gasstrom im zweiten Kanal angeordnet ist.

Erfindungsgemäß ist eine Partikelfalle, die durch ein Ende des zweiten Kanals, das in einer Gebrauchslage der Dosiereinheit unterhalb des Kreuzungspunktes liegt, gebildet wird, vorgesehen.

Erfindungsgemäß ist eine mit einem Verschlussstopfen verschließbare Reinigungsöffnung für die Partikelfalle vorgesehen.

Erfindungsgemäß ist der Basiskörper massiv ausgebildet und der erste Kanal als eine Bohrung in den Basiskörper eingebracht.

Der Winkel, unter dem der zweite Kanal den ersten Kanal schneidet, kann beispielsweise in einem Bereich von 30° bis 60°, insbesondere 30° bis 45° liegen. Durch die Wahl des Winkels wird erreicht, dass zum einen genügend Partikel des Precursors im Gasstrom des ersten Kanals mitgenommen werden und zum anderen Partikel oberhalb einer bestimmten Größe in der Partikelfalle verbleiben.

Es kann eine Dosieranordnung gebildet werden, umfassend mindestens zwei Dosiereinheiten, wobei die Dosiereinheiten in Reihe in den selben Gasstrom geschaltet sind, sodass dem Gasstrom mehrere Precursoren nacheinander zuführbar sind.

Ebenso kann eine Dosieranordnung gebildet werden, umfassend mindestens zwei Dosiereinheiten, wobei die Dosiereinheiten parallel geschaltet sind, sodass in jeder der Dosiereinheiten einem jeweiligen Gasstrom jeweils ein Precursor zuführbar ist, wobei die mit dem Precursor beaufschlagten Gasströme zusammengeführt sind.

Ebenso können gemischte Parallel-Reihen-Schaltungen von Dosiereinheiten vorgesehen sein.

Bei einer erfindungsgemäßen Verwendung der Dosiereinheit in einem Verfahren zur Abscheidung einer Schicht auf einem Substrat wird aus einem Arbeitsgas ein Plasmastrahl oder eine Flamme erzeugt, wobei mindestens ein Precursor mindestens einem Gasstrom in einer Dosiereinheit oder einer Dosieranordnung zugeführt und der mit dem Precursor beaufschlagte Gasstrom dem Arbeitsgas und/oder dem Plasmastrahl und/oder der Flamme zugeführt und der Precursor im Plasmastrahl oder der Flamme zur Reaktion gebracht wird, wobei mindestens ein Reaktionsprodukt mindestens eines der Precursoren auf einer Oberfläche des Substrats und/oder auf mindestens einer auf der Oberfläche angeordneten Schicht abgeschieden wird.

Der Precursor P kann eine undotierte Flüssigkeit sein. Erfindungsgemäß ist der Precursor eine Flüssigkeit mit gelöstem Feststoffanteil oder eine mit Partikeln, beispielsweise Nanopartikeln, beaufschlagte Flüssigkeit (Dispersion). Im Precursor vorhandene schwere Partikel, die vom Gasstrom im ersten Kanal nicht mitgenommen werden, fallen erfindungsgemäß in die durch das in Gebrauchslage der Dosiereinheit unterhalb des Kreuzungspunktes liegende, durch den Verschlussstopfen verschlossene, als Partikelfalle dienende, Ende des zweiten Kanals.

Als Nanopartikel wird in diesem Zusammenhang ein Verbund von Atomen und/oder Molekülen verstanden, dessen Größe typischerweise in einem Bereich von einem bis einigen hundert Nanometern liegt. Nanopartikel weisen gegenüber größeren Partikeln bzw. Festkörpern deutlich veränderte Eigenschaften beispielsweise in Bezug auf chemische Reaktivität, tribologische Eigenschaften oder elektrische Leitfähigkeit auf. Eine Verwendung dieser Nanopartikel im Bereich der Beschichtungstechnologie eröffnet neue Möglichkeiten der Oberflächenmodifikation.

Die erfindungsgemäße Dosiereinheit und die erfindungsgemäße Verwendung bei einem Verfahren zum Beschichten ermöglichen die Eindosierung des Precursors in Gasströme mit geringem Durchsatz, wobei eine Beschränkung der Größe der abgeschiedenen Partikel durch Variation von Verfahrensparametern möglich ist. Als Precursor werden beispielsweise silizium-, titan- und/oder aluminiumorganische Verbindungen verwendet. Es kann eine Vielzahl schichtbildender und Nanopartikel bildender Precursoren, beispielsweise Hexamethyldisiloxan (HMDSO), Titantetraisopropoxid (TTIP), Tetraethylorthosilikat (TEOS), Tetramethylorthosilikat (TMOS), ZnNO₃-, AgNO₃-Lösungen und andere Lösungen von Kationen, sowie Nanopartikel Dispersionen aus Metallen (Ag, Au, Ca, Cu) und/oder Metallverbindungen (ZnO, CoO) und/oder Nichtmetallverbindungen (Bornitrid, Kohlenstoff-Nanotubes) verwendet werden.

Bei der erfindungsgemäßen Verwendung wird die Dosiereinheit als Teil einer Beschichtungsvorrichtung verwendet, in der der mit dem Precursor beaufschlagte Gasstrom einem Arbeitsgas, einem bereits dotierten Arbeitsgas, einem aus dem Arbeitsgas gebildeten Plasma, einem Brenngas oder einer aus dem Brenngas gebildeten Flamme zugeführt wird, wobei der Precursor im Plasma oder in der Flamme umgesetzt und Reaktionsprodukte des Precursors als Partikel auf einer Oberfläche eines Substrats abgeschieden werden. Die Beschichtung kann bei Atmosphärendruck oder bei Niederdruck oder im Vakuum durchgeführt werden.

Das Verfahren wird bevorzugt bei Atmosphärendruck durchgeführt, wodurch auf besonders vorteilhafte Weise ein zeitaufwändiger Prozessschritt des Evakuierens einer Prozesskammer sowie Apparaturen zur Vakuumerzeugung, wie Vakuumpumpen und Prozesskammer, eingespart wird. Dadurch lässt sich das Verfahren ohne großen Aufwand in eine Prozesskette integrieren, die eine Herstellung und Vergütung des Substrats beinhaltet.

Insbesondere bei Verwendung eines Plasmas wird durch die Eindosierung des Precursors in der Dosiereinheit entfernt vom Plasmabrenner ein Ansprühen einer Plasmainnenelektrode mit dem Precursor vermieden, sodass diese weniger schnell verschmutzt. Auf diese Weise wird eine hohe Qualität des Plasmas über wesentlich längere Zeiträume ermöglicht, ohne dass eine mechanische Reinigung der Innenelektrode erforderlich wird. Ebenso werden Durchbrüche zwischen den Plasmaelektroden vermieden, bei denen anderenfalls Elektrodenmaterial in den Plasmastrom gelangen und die zu beschichtende Oberfläche verunreinigen kann.

Als Arbeitsgas und im Gasstrom in der Dosiereinheit kann ein Gas oder Aerosol, vorzugsweise Luft, Sauerstoff, Stickstoff, Edelgase, Wasserstoff, Kohlendioxid, gasförmige Kohlenwasserstoffe, Ammoniak oder ein Gemisch wenigstens zweier der vorgenannten Gase verwendet werden. Ammoniak eignet sich beispielsweise zur Bildung von Nitriden und kann eine katalytische Wirkung bei der Umsetzung des Precursors aufweisen.

In einer Ausgestaltung der Erfindung wird mindestens eine Gradientenschicht abgeschieden. Als Gradientenschicht soll eine Schicht verstanden werden, deren Zusammensetzung sich über ihre Dicke allmählich ändert. Der Begriff wird in Abgrenzung zu benachbarten Schichten mit verschiedenen Eigenschaften verwendet, die eine klare Grenze aufweisen.

Es kann mindestens eine Silizium-, Titan- und/oder Aluminiumoxidschicht abgeschieden werden.

Eine vorteilhafte Ausgestaltung der Erfindung sieht vor, dass ein Durchsatz des Arbeitsgases und/oder des Precursors gesteuert und/oder geregelt wird.

Weiterhin kann ein Nanopartikelanteil im Precursor und/oder in der Dispersion gesteuert und/oder geregelt werden. Neben dem Durchsatz des Arbeitsgases und/oder des Precursors steht somit eine weitere Möglichkeit zur Beeinflussung der Schichteigenschaften bzw. zum Aufbau von Gradienten innerhalb einer Schicht zur Verfügung. Durch geeignete Wahl dieser Prozessparameter und der verwendeten Precursoren und der verwendeten Nanopartikel sind beispielsweise folgende Eigenschaften des Substrats gezielt veränderbar: Kratzfestigkeit, Selbstheilungsfähigkeit, Reflexionsverhalten, Transmissionsverhalten, Fluoreszenzverhalten, Brechungsindex, Transparenz, Lichtstreuung, elektrische Leitfähigkeit, Reibung, Haftung, Hydrophilie, Hydrophobie, Oleophilie, Oleophobie, Oberflächenspannung, Oberflächenenergie, antikorrosive Wirkung, Schmutz abweisende Wirkung, Selbstreinigungsfähigkeit, photokatalytisches Verhalten, Antistressverhalten, Verschleißverhalten, chemische Widerstandsfähigkeit, biozides Verhalten, biokompatibles Verhalten, antibakterielles Verhalten, elektrostatisches Verhalten, elektrochrome Aktivität, photochrome Aktivität, und gasochrome Aktivität.

Als Substrate können unter anderem Metalle, Glas, Keramiken und Kunststoffe verwendet werden. Kunststoffmaterialien sind insbesondere aufgrund des moderaten Energieeintrags des Normaldruckplasmas beschichtbar, ohne dass das Substrat zerstört wird.

Ausführungsbeispiele der Erfindung werden im Folgenden anhand einer Zeichnung näher erläutert.

Darin zeigen:

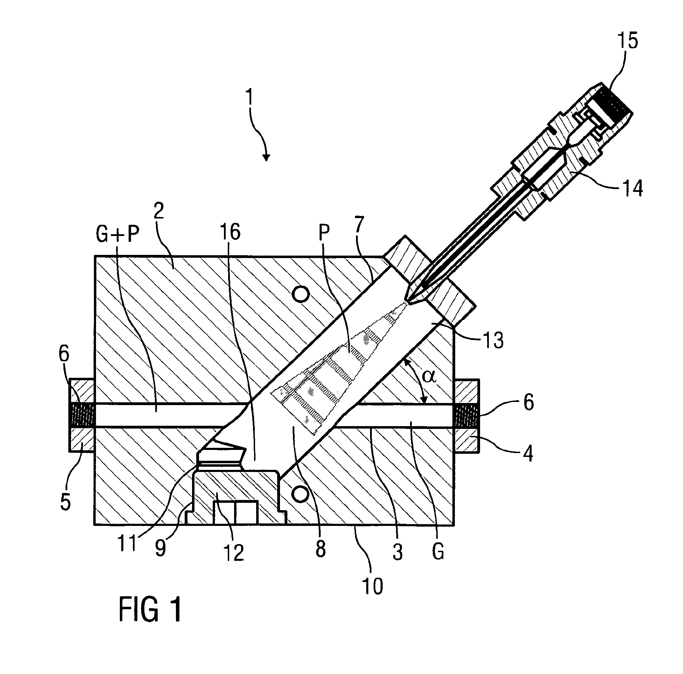

- Figur 1: eine Dosiereinheit zum Eindosieren eines Precursors in einen Gasstrom.

**Figur 1** zeigt eine Dosiereinheit 1 zum Eindosieren eines Precursors P in einen Gasstrom G. Die Dosiereinheit 1 umfasst einen Basiskörper 2, der massiv ausgebildet ist. Der Basiskörper 2 kann beispielsweise aus einem Kunststoff oder einem Metall, vorzugsweise Aluminium gebildet sein. Der Basiskörper 2 kann im Wesentlichen quaderförmig gebildet sein oder eine andere geometrische Form aufweisen.

Im Basiskörper 2 ist ein erster Kanal 3 für den Gasstrom G vorgesehen. Der erste Kanal 3 umfasst einen Gaseintritt 4 und einen Gasaustritt 5, die jeweils Adapter zum Verbinden mit Rohrleitungen, Schläuchen oder anderen Aggregaten umfassen. Im gezeigten Beispiel weisen der Gaseintritt 4 und der Gasaustritt 5 hierfür jeweils ein Innengewinde 6 auf. Ebenso sind Außengewinde, Verbindungen mit Überwurfmuttern, Bayonettverbindungen, Klemm- und Schnappverbindungen in der Art von Druckluft-Schnellkupplungen oder Hülsen zum Aufstecken von Schläuchen und anschließendem Sichern mit einer Schlauchschelle möglich.

Der erste Kanal 3 kann als eine Bohrung in den Basiskörper 2 eingebracht sein.

Der Basiskörper 2 weist einen zweiten Kanal 7 auf, der in einer Ebene mit dem ersten Kanal 3 liegt und diesen unter einem Winkel α schneidet. Der Winkel α liegt in einem Bereich von 0° bis 90°, bevorzugt von 0° bis 60°, besonders bevorzugt von 30° bis 45°, für einen kompakten Systemaufbau unter Beibehaltung der funktionellen Eigenschaften des Dosiersystems.

Der zweite Kanal 7 kann als eine Bohrung in den Basiskörper 2 eingebracht sein. Im dargestellten Beispiel ist der zweite Kanal 7 als ein Sackloch ausgeführt. Das nach einem Kreuzungspunkt 8 mit dem ersten Kanal 3 endet. Eine Reinigungsöffnung 9 ist als Bohrung rechtwinklig zu einer Außenfläche 10 des Basiskörpers 2 so in den Basiskörper 2 eingebracht, dass sie auf das Ende des als Sackloch ausgebildeten zweiten Kanals 7 trifft. Die Reinigungsöffnung weist ein Innengewinde 11 auf, in das ein Verschlussstopfen 12 einschraubbar ist.

An einem Eingang 13 des zweiten Kanals 3 ist eine Einsprühdüse 14 angeordnet, die ebenfalls ein Adapter zum Verbinden mit Rohrleitungen, Schläuchen oder anderen Aggregaten umfasst. Im gezeigten Beispiel weist der Adapter der Einsprühdüse 14 hierfür ein Innengewinde 15 auf. Ebenso sind Außengewinde, Verbindungen mit Überwurfmuttern, Bayonettverbindungen, Klemm- und Schnappverbindungen in der Art von Druckluft-Schnellkupplungen oder Hülsen zum Aufstecken von Schläuchen und anschließendem Sichern mit einer Schlauchschelle möglich.

Figur 1 zeigt die Dosiereinheit 1 in einer Gebrauchslage. Der erste Kanal 3 wird durch den Gasstrom G vom Gaseintritt 4 in Richtung Gasaustritt 5 durchströmt.

Durch die Einsprühdüse 14 wird der Precursor P, beispielsweise in flüssiger Form, in den zweiten Kanal 7 in Richtung des Kreuzungspunktes 8 eingedüst, wo der Precursor P vom Gasstrom G mitgerissen wird, sodass danach ein mit dem Precursor P beaufschlagter Gasstrom G+P, beispielsweise in Form eines Aerosols vorliegt. Eventuell im Precursor P vorhandene schwere Partikel, die vom Gasstrom G nicht mitgenommen werden, fallen in eine durch das in Gebrauchslage der Dosiereinheit 1 unterhalb des Kreuzungspunktes 8 liegende, durch den Verschlussstopfen 12 verschlossene Ende des zweiten Kanals 7, das daher als Partikelfalle 16 dient. Diese ist durch den Verschlussstopfen 12 leicht zugänglich und kann daher einfach gereinigt werden, wodurch ein schneller Wechsel zwischen verschiedenen Precursoren möglich ist.

Der Precursor P kann eine undotierte Flüssigkeit, eine Flüssigkeit mit gelöstem Feststoffanteil oder eine mit Partikeln, beispielsweise Nanopartikeln, beaufschlagte Flüssigkeit (Dispersion) sein.

Der Precursor kann ein siliziumhaltiger Precursor, beispielsweise ein siliziumorganischer Precursor, insbesondere HMDSO sein, sodass eine Silikatschicht abgeschieden wird.

Als Nanopartikel können beispielsweise Silber oder Kupfer enthalten sein, um in einer antibakteriellen Schicht abgeschieden zu werden.

Die Dosiereinheit 1 kann als Teil einer Beschichtungsvorrichtung verwendet werden, in der der mit dem Precursor beaufschlagte Gasstrom G+P einem Arbeitsgas, einem bereits dotierten Arbeitsgas, einem aus dem Arbeitsgas gebildeten Plasma, einem Brenngas oder einer aus dem Brenngas gebildeten Flamme zugeführt wird, wobei der Precursor P im Plasma oder in der Flamme umgesetzt und Reaktionsprodukte des Precursors P als Partikel auf einer Oberfläche eines Substrats abgeschieden werden. Die Beschichtung kann bei Atmosphärendruck oder bei Niederdruck oder im Vakuum durchgeführt werden. Insbesondere bei Verwendung eines Plasmas wird durch die Eindosierung des Precursors P in der Dosiereinheit 1 statt in einen Plasmabrenner ein Ansprühen einer Plasmainnenelektrode mit dem Precursor P vermieden, sodass diese weniger schnell verschmutzt. Auf diese Weise wird eine hohe Qualität des Plasmas über wesentlich längere Zeiträume ermöglicht, ohne dass eine mechanische Reinigung der Innenelektrode erforderlich wird.

Die Größe der Precursortröpfchen im Aerosol des mit dem Precursor beaufschlagten Gasstroms G+P und infolgedessen die Größe der abgeschiedenen Partikel kann beispielsweise durch Variation von Verfahrensparametern, beispielsweise einer Durchflussmenge des Gasstroms G und/oder der Einsprühdüse 14 und/oder einer Distanz der Einsprühdüse 14 vom Kreuzungspunkt 8 mit dem Gasstrom G beeinflusst werden.

Der Dosiereinheit 1 kann ein Gemisch von Precursoren P zugeführt werden. Ebenso können mehrere Dosiereinheiten in Reihe und/oder parallel in einem oder mehreren Gasströmen G angeordnet sein, wobei jeder der Dosiereinheiten 1 ein anderer Precursor P jeweils mit oder ohne Nanopartikel zugeführt wird. Diese Precursoren P können insbesondere verschiedene Aggregatzustände aufweisen und/oder untereinander chemisch unverträglich sein, was bei gemeinsamer Zuführung in einer Düse schwierig ist.

Beispielsweise kann als Precursor P eine Silbernitratlösung dem Gasstrom G und anschließend einem Plasmabrenner zugeführt werden. Die schichtbildende siliziumorganische chemische Vorläufersubstanz (bspw. HMDSO) kann zum einen dem Arbeitsgasstrom des Plasmabrenners direkt über eine vorgeschaltete Verdampfereinheit oder über eine in Reihe geschaltete weitere Zerstäubereinheit in den Gasstrom G+P eindosiert werden. Anschließend wird eine silberhaltige Silikatschicht auf flächigen Textilsubstraten abgeschieden.

### BEZUGSZEICHENLISTE

- 1: Dosiereinheit
- 2: Basiskörper
- 3: erster Kanal
- 4: Gaseintritt
- 5: Gasaustritt
- 6: Innengewinde
- 7: zweiter Kanal
- 8: Kreuzungspunkt
- 9: Reinigungsöffnung
- 10: Außenfläche
- 11: Innengewinde
- 12: Verschlusstopfen
- 13: Eingang
- 14: Einsprühdüse
- 15: Innengewinde
- 16: Partikelfalle
- α: Winkel
- G: Gasstrom
- G+P: mit dem Precursor beaufschlagter Gasstrom
- P: Precursor

## Patentansprüche

1. Dosiereinheit (1) zum Eindosieren eines Precursors (P) in einen Gasstrom (G), umfassend einen massiv ausgebildeten Basiskörper (2) mit einem ersten Kanal (3), der von einem Gaseintritt (4) zu einem Gasaustritt (5) vom Gasstrom durchströmbar und als eine Bohrung in den Basiskörper (2) eingebracht ist, und mit einem zweiten Kanal (7), der den ersten Kanal (3) unter einem Winkel (α) an einem Kreuzungspunkt (8) schneidet, wobei eine Einsprühdüse (14) zum Zuführen des Precursors (P) in den Gasstrom (G) im zweiten Kanal (7) angeordnet ist, wobei in einer Gebrauchslage der Dosiereinheit (1) unterhalb des Kreuzungspunktes (8) ein Ende des zweiten Kanals als eine Partikelfalle (16) ausgebildet ist, wobei eine mit einem Verschlussstopfen (12) verschließbare Reinigungsöffnung (9) für die Partikelfalle (16) vorgesehen ist.

2. Dosiereinheit nach Anspruch 1, **dadurch gekennzeichnet, dass** der Winkel (α) in einem Bereich von 30° bis 45° liegt.

3. Dosieranordnung, umfassend mindestens zwei Dosiereinheiten (1) nach einem der vorhergehenden Ansprüche, wobei die Dosiereinheiten (1) in Reihe in denselben Gasstrom (G) geschaltet sind, sodass dem Gasstrom (G) mehrere Precursoren (P) nacheinander zuführbar sind.

4. Dosieranordnung, umfassend mindestens zwei Dosiereinheiten (1) nach einem der vorhergehenden Ansprüche, wobei die Dosiereinheiten (1) parallel geschaltet sind, sodass in jeder der Dosiereinheiten (1) einem jeweiligen Gasstrom (G) jeweils ein Precursor (P) zuführbar ist, wobei die mit dem Precursor (P) beaufschlagten Gasströme (G+P) zusammengeführt sind.

5. Verwendung mindestens einer Dosiereinheit (1) nach einem der Ansprüche 1 oder 2 bei einem Verfahren zur Abscheidung einer Schicht auf einem Substrat, bei dem aus einem Arbeitsgas ein Plasmastrahl oder eine Flamme erzeugt wird, wobei der in dem massiv ausgebildeten Basiskörper (2) der Dosiereinheit (1) als eine Bohrung eingebrachte erste Kanal (3) vom Gaseintritt (4) zum Gasaustritt (5) von einem Gasstrom (G) durchströmt wird, wobei dem zweiten Kanal (7), der den ersten Kanal (3) unter einem Winkel (α) am Kreuzungspunkt (8) schneidet, durch die Einsprühdüse (14) ein als eine Flüssigkeit mit gelöstem Feststoffanteil oder als eine mit Partikeln beaufschlagte Flüssigkeit ausgebildeter Precursor (P) in Richtung des Kreuzungspunktes (8) zugeführt wird, wo der Precursor (P) vom Gasstrom (G) mitgerissen wird, wobei im Precursor (P) vorhandene schwere Partikel, die vom Gasstrom (G) nicht mitgenommen werden, in die durch das in Gebrauchslage der Dosiereinheit (1) unterhalb des Kreuzungspunktes (8) liegende, durch den Verschlussstopfen (12) verschlossene, als Partikelfalle (16) dienende, Ende des zweiten Kanals (7), fallen, wobei der mit dem Precursor (P) beaufschlagte Gasstrom (G+P) dem Arbeitsgas und/oder dem Plasmastrahl und/oder der Flamme zugeführt und der Precursor (P) im Plasmastrahl oder der Flamme zur Reaktion gebracht wird, wobei mindestens ein Reaktionsprodukt mindestens eines der Precursoren (P) auf einer Oberfläche des Substrats abgeschieden wird.

6. Verwendung nach Anspruch 5, wobei mindestens zwei Dosiereinheiten (1) zur Bildung einer Dosieranordnung in Reihe in denselben Gasstrom (G) geschaltet werden, sodass dem Gasstrom (G) mehrere Precursoren (P) nacheinander zugeführt werden.

7. Verwendung nach Anspruch 5 oder 6, wobei mindestens zwei Dosiereinheiten (1) zur Bildung einer Dosieranordnung parallel geschaltet werden, sodass in jeder der Dosiereinheiten (1) einem jeweiligen Gasstrom (G) jeweils ein Precursor (P) zugeführt wird, wobei die mit dem Precursor (P) beaufschlagten Gasströme (G+P) zusammengeführt werden.

8. Verwendung nach einem der Ansprüche 5 bis 7, **dadurch gekennzeichnet, dass** der Precursor (P) Nanopartikel enthält.

9. Verwendung nach Anspruch 8, **dadurch gekennzeichnet, dass** die Nanopartikel Silber und/oder Kupfer umfassen.

10. Verwendung nach einem der Ansprüche 5 bis 8, **dadurch gekennzeichnet, dass** die Abscheidung bei Atmosphärendruck erfolgt.

## Claims

1. Dosing unit (1) for dosing a precursor (P) into a gas stream (G), comprising a main body (2) which is of solid form and which has a first duct (3), through which the gas stream can flow from a gas inlet (4) to a gas outlet (5) and which is formed as a bore into the main body (2), and a second duct (7), which intersects the first duct (3) at an angle (α) at a crossing point (8), wherein an injection nozzle (14) for feeding the precursor (P) into the gas stream (G) is arranged in the second duct (7), wherein, below the crossing point (8) in a usage position of the dosing unit (1), one end of the second duct is in the form of a particle trap (16), wherein a cleaning opening (9), which can be closed off by way of a closure plug (12), is provided for the particle trap (16).

2. Dosing unit according to Claim 1, **characterized in that** the angle (α) lies in a range from 30° to 45°.

3. Dosing arrangement, comprising at least two dosing units (1) according to one of the preceding claims, wherein the dosing units (1) are positioned in series in the same gas stream (G), such that multiple precursors (P) can be fed to the gas stream (G) in succession.

4. Dosing arrangement, comprising at least two dosing units (1) according to one of the preceding claims, wherein the dosing units (1) are positioned in parallel such that, in each of the dosing units (1), a respective precursor (P) can be fed to a respective gas stream (G), wherein the gas streams (G+P) that have had the precursor (P) added to them are merged.

5. Use of at least one dosing unit (1) according to either of Claims 1 and 2 in a method for depositing a layer on a substrate, in which method a plasma jet or a flame is generated from a working gas, wherein the first duct (3) which is formed as a bore in the main body (2), of solid form, of the dosing unit (1) is flowed through from the gas inlet (4) to the gas outlet (5) by a gas stream (G), wherein the second duct (7), which intersects the first duct (3) at an angle (α) at the intersection point (8), has a precursor (P), which is in the form of a liquid with a dissolved solids fraction or as a liquid containing particles, fed to it by the injection nozzle (14) in the direction of the crossing point (8), where the precursor (P) is entrained by the gas stream (G), wherein heavy particles which are present in the precursor (P) and which are not entrained by the gas stream (G) fall into that end of the second duct (7) which, in the usage position of the dosing unit (1), is situated below the crossing point (8) and which is closed off by the closure plug (12) and which serves as a particle trap (16), wherein the gas stream (G+P) that has had the precursor (P) added to it is fed to the working gas and/or to the plasma jet and/or to the flame, and the precursor (P) is caused to react in the plasma jet or the flame, wherein at least one reaction product of at least one of the precursors (P) is deposited on a surface of the substrate.

6. Use according to Claim 5, wherein at least two dosing units (1) are, to form a dosing arrangement, positioned in series in the same gas stream (G), such that multiple precursors (P) are fed to the gas stream (G) in succession.

7. Use according to Claim 5 or 6, wherein at least two dosing units (1) are, to form a dosing arrangement, positioned in parallel, such that, in each of the dosing units (1), a respective precursor (P) is fed to a respective gas stream (G), wherein the gas streams (G+P) that have had the precursor (P) added to them are merged.

8. Use according to one of Claims 5 to 7, **characterized in that** the precursor (P) comprises nanoparticles.

9. Use according to Claim 8, **characterized in that** the nanoparticles comprise silver and/or copper.

10. Use according to one of Claims 5 to 8, **characterized in that** the deposition is performed at atmospheric pressure.

## Revendications

1. Unité de dosage (1) pour le dosage d'un précurseur (P) dans un flux de gaz (G), comprenant un corps de base (2) réalisé sous forme massive, avec un premier canal (3) qui peut être traversé par le flux de gaz depuis une entrée de gaz (4) jusqu'à une sortie de gaz (5) et qui est introduit sous forme d'alésage dans le corps de base (2), et avec un deuxième canal (7) qui coupe le premier canal (3) au niveau d'un point d'intersection (8) en formant un angle (α), une buse de pulvérisation (14) pour acheminer le précurseur (P) dans le flux de gaz (G) étant disposée dans le deuxième canal (7), une extrémité du deuxième canal étant réalisée sous forme de piège à particules (16) dans une position d'utilisation de l'unité de dosage (1) sous le point d'intersection (8), une ouverture de nettoyage (9) pour le piège à particules (16), pouvant être fermée avec un bouchon de fermeture (12), étant prévue.

2. Unité de dosage selon la revendication 1, **caractérisée en ce que** l'angle (α) est compris dans une plage de 30° à 45°.

3. Agencement de dosage comprenant au moins deux unités de dosage (1) selon l'une quelconque des revendications précédentes, dans lequel les unités de dosage (1) sont montées en série dans le même flux de gaz (G) de sorte que plusieurs précurseurs (P) puissent être acheminés les uns après les autres au flux de gaz (G).

4. Agencement de dosage comprenant au moins deux unités de dosage (1) selon l'une quelconque des revendications précédentes, dans lequel les unités de dosage (1) sont montées en parallèle de sorte que dans chacune des unités de dosage (1) un précurseur (P) puisse à chaque fois être acheminé à un flux de gaz respectif (G), les flux de gaz (G+P) sollicités par le précurseur (P) étant réunis.

5. Utilisation d'au moins une unité de dosage (1) selon l'une quelconque des revendications 1 ou 2, dans un procédé de dépose d'une couche sur un substrat, dans lequel, à partir d'un gaz de travail, un jet de plasma ou une flamme est produit(e), le premier canal (3), introduit sous forme d'alésage dans le corps de base réalisé sous forme massive (2) de l'unité de dosage (1), étant traversé par un flux de gaz (G) depuis l'entrée de gaz (4) jusqu'à la sortie de gaz (5), un précurseur (P), réalisé sous forme de liquide avec une proportion de matières solides dissoute ou sous forme de liquide sollicité avec des particules, étant acheminé à travers la buse de pulvérisation (14) dans la direction du point d'intersection (8) au deuxième canal (7) qui coupe le premier canal (3) au niveau du point d'intersection (8) en formant un angle (α), où le précurseur (P) est entraîné par le flux de gaz (G), les particules lourdes présentes dans le précurseur (P) qui ne sont pas entraînées par le flux de gaz (G) tombant dans l'extrémité du deuxième canal (7) servant de piège à particules (16) fermée par le bouchon de fermeture (12) et située, en position d'utilisation de l'unité de dosage (1), en dessous du point d'intersection (8), le flux de gaz (G+P) sollicité par le précurseur (P) étant acheminé au gaz de travail et/ou au jet de plasma et/ou à la flamme et le précurseur (P) étant introduit dans le jet de plasma ou dans la flamme en vue d'une réaction, au moins un produit de réaction d'au moins l'un des précurseurs (P) étant déposé sur une surface du substrat.

6. Utilisation selon la revendication 5, dans laquelle au moins deux unités de dosage (1), pour la formation d'un agencement de dosage, sont montées en série dans le même flux de gaz (G), de sorte que plusieurs précurseurs (P) soient acheminés les uns après les autres au flux de gaz (G).

7. Utilisation selon la revendication 5 ou 6, dans laquelle au moins deux unités de dosage (1) sont montées en parallèle pour former un agencement de dosage, de sorte que dans chacune des unités de dosage (1) un précurseur (P) soit à chaque fois acheminé à un flux de gaz respectif (G), les flux de gaz (G+P) sollicités par le précurseur (P) étant réunis.

8. Utilisation selon l'une quelconque des revendications 5 à 7, **caractérisée en ce que** le précurseur (P) contient des nanoparticules.

9. Utilisation selon la revendication 8, **caractérisée en ce que** les nanoparticules comprennent de l'argent et/ou du cuivre.

10. Utilisation selon l'une quelconque des revendications 5 à 8, **caractérisée en ce que** le dépôt s'effectue à la pression atmosphérique.
